# EUROPÄISCHE PATENTSCHRIFT

(11) **EP 2 791 383 B1**
(45) Veröffentlichungstag und Bekanntmachung des Hinweises auf die Patenterteilung: **09.12.2015**
(21) Anmeldenummer: 12819053.5
(22) Anmeldetag: 10.12.2012
(51) Int. Cl.: C23C 14/00, B05D 7/00, B41J 2/00, C09D 5/00, C23C 14/02, C08J 7/04, B32B 27/00, C09D 7/12, B44C 5/00, B41M 1/26

(54) **VERFAHREN ZUR HERSTELLUNG VON METALLSCHICHTEN ENTHALTENDEN BESCHICHTUNGSSYSTEMEN ZUR VEREDELUNG VON KUNSTSTOFFOBERFLÄCHEN**
METHOD FOR PRODUCING COATING SYSTEMS CONTAINING METAL LAYERS FOR FINISHING PLASTIC SURFACES
PROCÉDÉ DE PRODUCTION DE SYSTÈMES DE REVÊTEMENT CONTENANT DES COUCHES MÉTALLIQUES, SERVANT À L'AMÉLIORATION DE SURFACES EN MATIÈRE PLASTIQUE

(30) Priorität: 14.12.2011 DE 102011120940
(43) Veröffentlichungstag der Anmeldung: 22.10.2014
(73) Patentinhaber: Mankiewicz Gebr. & Co. GmbH & Co. KG, 21107 Hamburg (DE)
(72) Erfinder: DE ROSSI, Umberto, 22844 Norderstedt (DE); ROTHS, Klaus, 48683 Ahaus (DE)
(86) Internationale Anmeldenummer: PCT/DE2012/001177
(87) Internationale Veröffentlichungsnummer: WO 2013/087058

(56) Entgegenhaltungen:
- WO-A1-99/31534
- WO-A1-2008/035186
- DE-A1-102008 063 837
- JP-A- 2005 134 610
- JP-A- 2011 152 774
- US-A1- 2005 219 626

## Beschreibung

Die vorliegende Erfindung betrifft ein Verfahren zur Herstellung eines Beschichtungssystems zur Veredelung und Dekoration von Bauteilen, das auch in inline-Prozessen eingesetzt werden kann. Die Erfindung betrifft weiterhin Beschichtungssysteme für Kunststoffoberflächen, die ein oder mehrere Metallschichten enthalten.

Zum Aufbringen von Metallschichten auf Oberflächen von Substraten sind als vakuumbasierte Beschichtungsverfahren physikalische Gasabscheide- oder PVD-Verfahren (PVD: Physical Vapor Deposition) bekannt. Hierbei wird mit Hilfe physikalischer Verfahren das Ausgangsmaterial bzw. der Beschichtungsstoff in die Gasphase überführt. Das gasförmige Material kondensiert auf dem zu beschichtenden Substrat und bildet so die Zielschicht oder Beschichtung. Zur Verdampfung des Ausgangsmaterials werden unterschiedliche Verfahren eingesetzt. So kann das Ausgangsmaterial beispielsweise über Kathodenzerstäubung oder Sputtern in die Gasphase überführt werden. Unter dem Begriff Sputtern wird im Folgenden die Sputterdeposition verstanden, die üblicherweise zur Herstellung dünner Schichten eingesetzt wird. Gesputterte Dünnschichten werden unter anderem auch zur Oberflächenveredelung eingesetzt.

Die sehr niedrigen Prozesstemperaturen der PVD-Verfahren ermöglichen eine Beschichtung niedrigschmelzender Kunststoffe. Die Oberfläche eines Kunststoffsubstrats oder Kunststoffbauteils ist jedoch meist nicht ausreichend fehlerfrei. Es muss daher in Regel ein Primer unter der PVD-Schicht appliziert werden. Üblicherweise werden hierzu zweikomponentige lösemittelhaltige Primer eingesetzt wie beispielsweise Polyurethanprimer, die eine thermische Trocknung erfordern. Die üblichen Trocknungsbedingungen sind dabei 30 Minuten bei 80°C. Zum Aufbau von Reliefstrukturen sind thermisch trocknende Primer jedoch nicht geeignet. Auch ist eine im PVD-Verfahren applizierte Metallschicht für einige Anwendungen wie zum Beispiel im Automobil-Innenraum mechanisch nicht ausreichend stabil. Daher wird meist noch eine weitere Schicht auf die Metallschicht aufgebracht, beispielsweise ein Klarlack.

Darüber hinaus kann die Metallschicht in den bekannten Beschichtungssystemen nur schwer dekoriert werden. Das Anbringen von Mustern oder Schriften ist hier ausschließlich über die Laserung des Klarlacks möglich. Eine Laserung ist jedoch aufwändig und verletzt bzw. beschädigt die Oberfläche des Klarlacks. Vor allem bilden sich durch die Laserung offene Kanten, von denen aus bei Feuchtebelastung Unterwanderung stattfinden kann, wodurch der Gesamtaufbau der Beschichtung geschwächt wird. Die zusätzliche Laserung ist in Inline-Verfahren nicht möglich. Weiterhin kann dieses Verfahren auch keine Reliefstruktur abbilden Patentdokumente WO2008/035186 und DE102008063837 beschreiben Verfahren zur Herstellung von dekorativen Beschichtungen mittels Inkjet -Druckverfahren. .

Es ist somit Aufgabe der vorliegenden Erfindung, verbesserte Mittel und Verfahren zur Oberflächenveredelung von Bauteilen zur Verfügung zu stellen, insbesondere Beschichtungsverfahren und Beschichtungssysteme, welche eine Metallschicht aufweisen.

Gelöst wird diese Aufgabe durch Verfahren gemäß Anspruch 1 und Beschichtungssystem gemäß Anspruch 6. Bevorzugte Ausführungsformen offenbaren die Unteransprüche und die Beschreibung.

Das erfindungsgemäße Verfahren weist mehrere Schritte zum Aufbau eines Beschichtungssystems direkt auf der Oberfläche eines Bauteils auf. Dabei wird zunächst eine erste tintenhaltige Schicht auf der Oberfläche des Bauteils angebracht. Die Oberfläche kann direkt beschichtet werden oder auch mit einer Grundierung oder Primerschicht versehen sein. Auf der tintenhaltigen Schicht wird dann eine Metallschicht angebracht. Abschließend wird auf der Metallschicht eine Klarlackschicht angebracht.

Die erste Schicht wird erfindungsgemäß aus einer oder mehreren UV-härtenden Tinten hergestellt. Dazu wird in Schritt (a) auf der Bauteiloberfläche zumindest eine Tinte mittels üblicher Inkjet-Druckverfahren unter Verwendung eines handelsüblichen Inkjet-Druckkopfs aufgetragen. Unter dem Begriff Inkjet-Druckverfahren werden im Folgenden sowohl Tintenstrahl- als auch Dropon-demand-Verfahren verstanden. Die aufgetragenen Tinten werden in Schritt (b) durch die Bestrahlung mit UV-Licht zur tintenhaltigen Schicht ausgehärtet. Durch den Einsatz von UV-härtenden Tinten im Inkjet-Druckverfahren kann in dieser ersten Schicht zusätzlich in der üblichen, dem Fachmann bekannten Weise eine reliefartige Schichtoberfläche erzielt werden. In Kombination mit der darüberliegenden Metallschicht ergibt sich somit eine Licht-Schatten-Wechselwirkung auf der Bauteiloberfläche. Bekannte Inkjet-Tinten sind dünnflüssige Tinten auf Wasser- oder Lösemittelbasis üblicherweise mit einer Viskosität im Bereich von 4 bis 30 mPas. Sie weisen neben den Farbmitteln einen hohen Lösemittelanteil und einen geringen Bindemittelanteil auf. Als Farbmittel werden beispielsweise lösliche Farbstoffe mit hoher Lichtechtheit und Thermostabilität und/oder feinteilige Pigmente mit einer Teilchengröße unter 3 µm eingesetzt. Für den Einsatz im erfindungsgemäßen Verfahren geeignete UV-härtende Inkjet-Tinten enthalten Oligomere, Reaktivverdünner und Photoinitiatoren, welche den Aushärtungsprozess in Gang setzen.

Auf der ersten, tintenhaltigen Schicht wird in Schritt (c) eine dünne Metallschicht aufgebracht. Erfindungsgemäß wird diese Metallschicht mittels PVD-Verfahren, bevorzugt durch Sputtern oder Bedampfen, erzeugt. Für die Beschichtung geeignete Metalle sind zum Beispiel Aluminium und Chrom. In einer weiteren Ausführungsform der vorliegenden Erfindung kann die Farbe der Metallschicht durch den Einsatz von Reaktivgasen geändert werden.

Anschließend wird auf der Metallschicht eine Klarlackschicht hergestellt. In Schritt (d) werden die Klarlacke auf der Metallschicht aufgebracht und in Schritt (e) ausgehärtet. Klarlacke sind Beschichtungsstoffe, die auf einer Oberfläche eine transparente Schicht oder Beschichtung ergeben, die vor allem schützenden Eigenschaften hat. Klarlacke enthalten in der Regel keine Pigmente oder Füllstoffe. Gegebenenfalls können ihnen lösliche Farbstoffe oder transparente Pigmente zugesetzt werden. Erfindungsgemäß geeignet sind die dem Fachmann geläufigen und bekannten Klarlacke. Erfindungsgemäß bevorzugt werden UV-härtende Lacke eingesetzt. Im Unterschied zu den eingesetzten UV-härtenden Tinten enthalten die Klarlacke zur Erhöhung der Stabilität der ausgehärteten Schicht deutlich höhere Bindemittelanteile. Zudem werden sie in höheren Schichtdicken aufgetragen als die Tinten. Die Klarlacke können in einem dem Fachmann geläufigen Verfahren wie beispielsweise Coaten, Airbrush, Spritzen, Sprühen, Rakeln oder Walzen appliziert werden. Erfindungsgemäß bevorzugt werden die Klarlacke über Sprühpistolen aufgebracht. In einer besonders bevorzugten Ausführungsform werden die Klarlacke ebenfalls durch Inkjet-Druckverfahren appliziert.

In einer weiteren Ausführungsform der Erfindung wird die Bauteiloberfläche zunächst mit einer Grundierung versehen. Auf diese Grundierung wird erfindungsgemäß die erste Schicht in dem gewünschtem Muster oder Dekor mit zumindest einer geeigneten Tinte mittels eines handelsüblichen Inkjet-Druckkopfes gedruckt. Die erfindungsgemäße Grundierung oder Primerschicht dient zur Haftvermittlung für das gesamte Beschichtungssystem auf der Oberfläche des Bauteils. Dem Fachmann sind die Primer bekannt und geläufig, welche zur Grundierung der eingesetzten Bauteilmaterialien verwendet werden können und üblicherweise verwendet werden. Bevorzugt werden UV-härtende Primer eingesetzt, welche in einem üblichen Verfahren wie beispielsweise durch Coaten, Airbrush, Spritzen, Sprühen, Rakeln oder Walzen auf die Bauteiloberfläche aufgebracht werden. Erfindungsgemäß bevorzugt werden die Primer über Sprühpistolen aufgebracht. In einer besonders bevorzugten Ausführungsform werden die Primer ebenfalls durch Inkjet-Druckverfahren appliziert.

Das erfindungsgemäße Verfahren wird bevorzugt zur Beschichtung von Bauteilen eingesetzt. Geeignete Bauteilmaterialien oder Substrate sind Kunststoffe wie beispielsweise normales ABS (Acrylnitril-Butadien-Styrol Copolymerisat) oder ABS-PC (Acrylnitril-Butadien-Styrol Copolymerisat mit Polycarbonat). Weitere geeignete Substrate sind Glas und Melamin wie beispielsweise Melaminlaminate oder melaminkaschierten Werkstoffe. Das erfindungsgemäße Beschichtungsverfahren ermöglicht eine Dekorierung der Metallschicht ohne Verletzung der Deckschicht, so dass keine Destabilisierung des Gesamtaufbaus stattfindet. Die erhaltenen Beschichtungen weisen daher Beständigkeiten auf, die den üblichen Automobilspezifikationen genügen.

Die erfindungsgemäß bevorzugt eingesetzten UV-härtenden Tinten, Klarlacke und Primer härten darüber hinaus vergleichsweise schnell aus, so dass eine schnelle Weiterbearbeitung der beschichteten Oberflächen möglich ist. Das erfindungsgemäße Verfahren kann daher ohne Weiteres in bestehende Lackierprozesse integriert werden und bietet so die Möglichkeiten eines Inline-Veredelungsprozesses.

Die der vorliegenden Erfindung zugrunde liegende Aufgabe wird auch gelöst durch ein Beschichtungssystem mit folgendem Schichtaufbau:
- eine erste tintenhaltigen Schicht hergestellt aus ein oder mehreren UV-härtenden Inkjet-Tinten,
- ein oder mehrere Metallschichten und
- eine abschließende Klarlackschicht hergestellt aus ein oder mehreren Klarlacken.

Erfindungsgemäß bevorzugt weisen die eingesetzten Tinten 5 bis 50 Gew.-% Oligomere, 20 bis 80 Gew.-% Reaktivverdünner und bis zu 15 Gew.-% Pigmente jeweils bezogen auf die Gesamtmasse der Tinte auf. Bevorzugt enthalten die Tinten 5 bis 30 Gew.-%, besonders bevorzugt 5 bis 15 Gew.-% Oligomer bezogen auf Gesamtmasse der Tinte. Geeignete Oligomere sind beispielsweise aliphatische und aromatische Urethanacrylate, Polyetheracrylate und Epoxyacrylate, wobei die Acrylate mono- oder polyfunktionell sein können zum Beispiel di-, tri- bis zu hexa- und decafunktionell. Bevorzugt enthalten die Tinten weiterhin 50 bis 80 Gew.-%, besonders bevorzugt 70 bis 80 Gew.-%, mono-, di- und/oder trifunktionelle Reaktivverdünner bezogen auf Gesamtmasse der Tinte. Geeignete Reaktivverdünner sind beispielsweise Dipropylenglykoldiacrylat, Tripropylenglykoldiacrylat, Tetrahydrofurfurylacrylat, Isobornylacrylat und Isodecylacrylat.

Weiterhin können die erfindungsgemäß eingesetzten Tinten zusätzlich ein oder mehrere Pigmente enthalten in einer Menge von insgesamt bis zu 15 Gew.-% bezogen auf die Gesamtmasse der Tinte. Geeignete Pigmente sind beispielsweise Pigment Yellow 213, PY 151, PY 93, PY 83, Pigment Red 122, PR 168, PR 254, PR 179, Pigment Red 166, Pigment Red 48:2, Pigment Violet 19, Pigment Blue 15:1, Pigment Blue 15:3, Pigment Blue 15:4, Pigment Green 7, Pigment Green 36, Pigment Black 7 oder Pigment White 6.

Die erfindungsgemäß eingesetzten Tinten enthalten darüber hinaus die üblichen, dem Fachmann geläufigen Photoinitiatoren. Art und eingesetzte Menge des Photoinitiatoren hängen insbesondere von der eingesetzten UV-Strahlung ab. Üblicherweise werden Photoinitiatoren in Mengen 1 bis 5 Gew.-% bezogen auf das Gesamtgewicht der Tinte eingesetzt. Zusätzlich können den Tinten zur Einstellung ihrer Eigenschaften noch weitere Additive zugesetzt werden wie beispielsweise Dispergieradditive, Entschäumer und UV-Absorber.

Die erfindungsgemäßen Metallschichten enthalten bevorzugt Chrom oder Aluminium.

Klarlacke sind Beschichtungsstoffe, die auf einer Oberfläche eine transparente Schicht oder Beschichtung ergeben, die vor allem schützenden Eigenschaften hat. Die Klarlacke enthalten in der Regel keine Pigmente oder Füllstoffe. Gegebenenfalls können ihnen lösliche Farbstoffe oder transparente Pigmente zugesetzt werden. In den erfindungsgemäßen Beschichtungssystemen wird die Klarlackschicht als abschließende Schicht eingesetzt, welche die darunterliegenden Schichten vor mechanischen Beschädigungen und Witterungseinflüssen schützt. Erfindungsgemäß bevorzugt sind UV-härtende Klarlacke, die bevorzugt 15 bis 50 Gew.-% Oligomere und 20 bis 80 Gew.-% Reaktivverdünner jeweils bezogen auf die Gesamtmasse des Klarlacks aufweisen. Bevorzugt enthalten die Klarlacke 25 bis 50 Gew.-%, besonders bevorzugt 30 bis 50 Gew.-%, Oligomer bezogen auf die Masse des Klarlacks. Geeignete Oligomere sind beispielsweise aliphatische und aromatische Urethanacrylate, Polyetheracrylate und Epoxyacrylate, wobei die Acrylate mono- oder polyfunktionell sein können zum Beispiel di-, tri- bis zu hexa- und decafunktionell. Die Klarlacke enthalten bevorzugt 30 bis 75 Gew.-%, besonders bevorzugt 40 bis 60 Gew.-%, mono-, di- und/oder trifunktionellen Reaktivverdünner bezogen auf die Masse des Klarlacks. Geeignete Reaktivverdünner sind beispielsweise Dipropylenglykoldiacrylat, Tripropylenglykoldiacrylat, Tetrahydrofurfurylacrylat, Isobornylacrylat und Isodecylacrylat.

Die erfindungsgemäß eingesetzten Klarlacke enthalten darüber hinaus die üblichen, dem Fachmann geläufigen Photoinitiatoren. Art und eingesetzte Menge des Photoinitiatoren hängen insbesondere von der eingesetzten UV-Strahlung ab. Üblicherweise werden Photoinitiatoren in Mengen 1 bis 5 Gew.-% bezogen auf das Gesamtgewicht des Klarlacks eingesetzt. Zusätzlich können den Klarlacken zur Einstellung ihrer Eigenschaften weitere Additive zugesetzt werden wie beispielsweise Dispergieradditive, Entschäumer und UV-Absorber.

Die erfindungsgemäßen Beschichtungssysteme werden bevorzugt zur Beschichtung von Kunststoff- und Glasoberflächen eingesetzt. Geeignete Kunststoffe sind beispielsweise Kunststoffe wie normales ABS (Acrylnitril-Butadien-Styrol Copolymerisat), ABS-PC (Acrylnitril-Butadien-Styrol Copolymerisat mit Polycarbonat) und Melamine wie zum Beispiel Melaminlaminate oder melaminkaschierten Werkstoffe. Das erfindungsgemäße Beschichtungssystem ermöglicht eine Dekorierung der Metallschicht ohne Verletzung der Deckschicht, so dass keine Destabilisierung des Gesamtaufbaus stattfindet. Damit weist das erfindungsgemäße Beschichtungssystem Beständigkeiten auf, die den üblichen Automobilspezifikationen genügen.

Die folgende Formulierung dient lediglich als Beispiel und hat keine einschränkende Wirkung auf die Erfindung.

### Beispiel

### Tinte:

| **Bestandteil** | **Menge [%-Masse]** |
|---|---|
| Oligomer | 10 |
| Reaktivverdünner | 75 |
| Pigment | 10 |
| Photoinitiator | 2 |
| Additive | 3 |

### Metallschicht:

| **Bestandteil** |
|---|
| Chrom oder Aluminium |

### Klarlack:

| **Bestandteil** | **Menge [%-Masse]** |
|---|---|
| Oligomer | 40 |
| Reaktivverdünner | 50 |
| Photoinitiator | 5 |
| weitere Additive | 5 |

## Patentansprüche

1. Verfahren zur Beschichtung von Bauteiloberflächen aufweisend die Schritte
(a) Aufbringen von zumindest einer Tinte auf die Oberfläche eines Bauteils mittels Inkjet-Verfahren,
(b) Aushärten der aufgebrachten Tinten durch Bestrahlen mit UV-Licht zu einer tintenhaltigen Schicht,
(c) Aufbringen zumindest einer dünnen Metallschicht auf die tintenhaltige Schicht mittels PVD-Verfahren,
(d) Aufbringen zumindest eines Klarlacks auf die Metallschicht,
(e) Aushärten der Klarlacke zu einer Klarlackschicht.

2. Verfahren nach Anspruch 1, **dadurch gekennzeichnet, dass** vor dem Aufbringen der Tinte in Schritt (a) zumindest ein Primer auf die zu beschichtende Bauteiloberfläche aufgebracht und zu einer Primerschicht ausgehärtet wird.

3. Verfahren nach einem der Ansprüche 1 oder 2, **dadurch gekennzeichnet, dass** in Schritt (c) die Metallschicht mittels Sputtern oder Bedampfen aufgebracht wird.

4. Verfahren nach einem der voranstehenden Ansprüche,
**dadurch gekennzeichnet, dass** in Schritt (e) die Klarlacke durch Bestrahlen mit UV-Licht ausgehärtet werden.

5. Verfahren nach einem der voranstehenden Ansprüche,
**dadurch gekennzeichnet, dass** die eingesetzten Bauteile Acrylnitril-Butadien-Styrol-Copolymerisate, Acrylnitril-Butadien-Styrol-Copolymerisate mit Polycarbonaten, Melamin oder Glas enthalten.

6. Beschichtungssystem für eine Substratoberfläche aufweisend eine erste tintenhaltigen Schicht hergestellt aus ein oder mehreren UV-härtenden Inkjet-Tinten und zumindest eine Metallschicht sowie eine abschließende Klarlackschicht hergestellt aus ein oder mehreren Klarlacken.

7. Beschichtungssystem nach Anspruch 6, **dadurch gekennzeichnet, dass** die eingesetzten Tinten 5 bis 50 Gew.-% Oligomere, 20 bis 80 Gew.-% Reaktivverdünner und bis zu 15 Gew.-% Pigmente jeweils bezogen auf die Gesamtmasse der Tinte aufweisen.

8. Beschichtungssystem nach einem der Ansprüche 6 oder 7, **dadurch gekennzeichnet, dass** die Metallschicht Chrom oder Aluminium enthält.

9. Beschichtungssystem nach einem der Ansprüche 6 bis 8, **dadurch gekennzeichnet, dass** die eingesetzten Klarlacke UV-härtende Klarlacke sind.

10. Beschichtungssystem nach Anspruch 9, **dadurch gekennzeichnet, dass** die Klarlacke 15 bis 50 Gew.-% Oligomere und 20 bis 80 Gew.-% Reaktivverdünner jeweils bezogen auf die Gesamtmasse des Klarlacks aufweisen.

## Claims

1. Method for the coating of components, comprising the steps
(a) Application of at least one ink type to the surface of a component by inkjet printing,
(b) Hardening of the applied ink types by irradiation with UV light to an ink-bearing layer,
(c) Application of at least one thin metallic layer to the ink-bearing layer by the physical vapour deposition (PVD) method,
(d) Application of at least one transparent varnish to the metallic layer,
(e) Hardening of the transparent varnishes to a transparent varnish layer.

2. Method according to Claim 1, **characterised by** the application of at least one primer to the component surface to be coated before application of the ink in step (a) and hardening to a primer coating.

3. Method according to Claim 1 or Claim 2, **characterised by** the application of the metallic layer in step (c) by sputtering or vapour deposition.

4. Method according to one of the above claims, **characterised by** hardening the transparent varnishes in step (e) by irradiation with UV light.

5. Method according to one of the above claims, **characterised by** components containing acrylonitrile butadiene styrol copolymers with polycarbonates, melamine or glass.

6. Coating system for a substrate surface, comprising an initial ink layer produced from one or more UV-hardening inkjet inks and at least one metallic layer together with a final transparent varnish layer of one or more transparent varnishes.

7. Coating system according to Claim 6, **characterised by** inks with 5 to 50 weight % oligomers, 20 to 80 weight % reactive diluent, and up to 15 weight % pigments relative to the total weight of the inks.

8. Coating system according to Claim 6 or Claim 7, **characterised by** the metallic layer containing chromium or aluminium.

9. Coating system according to Claim 6 or Claim 8, **characterised by** the application of UV-hardening transparent varnishes.

10. Coating system according to Claim 9, **characterised by** transparent varnishes containing 5 to 50 weight % oligomers and 20 to 80 weight % reactive diluent relative to the total weight of the transparent varnish.

## Revendications

1. Procédé de revêtement de surfaces de composants comportant les étapes
(a) application d'au moins une encre sur la surface d'un composant au moyen d'un procédé à jet d'encre,
(b) durcissement des encres appliquées par irradiation de lumière UV en une couche contenant de l'encre,
(c) application d'au moins une fine couche de métal sur la couche contenant de l'encre au moyen d'un procédé PVD,
(d) application d'au moins un vernis incolore sur la couche en métal,
(e) durcissement des vernis incolores en une couche de vernis incolore.

2. Procédé conformément à la revendication 1, **caractérisé en ce que**, avant l'application de l'encre à l'étape (a), au moins un apprêt est appliqué sur la surface du composant à recouvrir et durci en une couche d'apprêt.

3. Procédé conformément à l'une des revendications 1 ou 2, **caractérisé en ce que**, à l'étape (c), la couche de métal est appliquée au moyen d'une pulvérisation cathodique ou d'une valorisation.

4. Procédé conformément à l'une des revendications susmentionnées, **caractérisé en ce que**, à l'étape (e), les vernis incolores sont durcis au moyen d'une irradiation de lumière UV.

5. Procédé conformément à l'une des revendications susmentionnées, **caractérisé en ce que** les composants employés contiennent des copolymères d'acrylonitrile-butadiène-styrène, des copolymères d'acrylonitrile-butadiène-styrène avec des polycarbonates, de la mélamine ou du verre.

6. Système de revêtement pour une surface de substrat présentant une première couche contenant de l'encre et fabriquée à partir d'une ou de plusieurs encres pour jet d'encre durcissant aux UV et au moins une couche de métal ainsi qu'une couche finale de vernis incolore fabriquée à partir d'un ou de plusieurs vernis incolores.

7. Système de revêtement conformément à la revendication 6, **caractérisé en ce que** les encres employées contiennent 5 à 50 % en poids d'oligomères, 20 à 80 % en poids de diluants réactifs et jusqu'à 15 % en poids de pigments, respectivement par rapport à la masse totale de l'encra.

8. Système de revêtement conformément à l'une des revendications 6 ou 7, **caractérisé en ce que** la couche de métal contient du chrome ou de l'aluminium.

9. Système de revêtement conformément à l'une des revendications 6 à 8, **caractérisé en ce que** les vernis incolores employés sont des vernis incolores durcissant aux UV.

10. Système de revêtement conformément à la revendication 9, **caractérisé en ce que** les vernis incolores contiennent 15 à 50 % en poids d'oligomères et 20 à 80 % en poids de diluants réactifs, respectivement par rapport à la masse total du vernis incolore.
